# EUROPEAN PATENT APPLICATION

(11) **EP 2 045 814 A1**
(43) Date of publication of application: **08.04.2009**
(21) Application number: 07425616.5
(22) Date of filing: 03.10.2007
(51) Int. Cl.: G11C 16/02, G11C 16/10, G11C 17/14, G11C 16/26

(54) **Method and device for irreversibly programming and reading nonvolatile memory cells**

(71) Applicant: STMicroelectronics S.r.l., 20041 Agrate Brianza (MI) (IT)
(72) Inventor: Resta, Claudio, 23030 Villa di Tirano (IT); Bedeschi, Ferdinando, 20039 Biassono (IT); Pellizzer, Fabio, 20041 Cornate d'Adda (IT)
(74) Representative: Bartle, Robin Jonathan

(57) **Abstract**

In a nonvolatile memory device, data stored in a memory cell (21a, 21b) are associated to whether or not the memory cell is switchable between a first state and a second state. Memory cells are irreversibly programmed by applying an irreversible programming signal (I_{IRP}), such that the nonvolatile memory cells (21a) are made not switchable between the first state and the second state in response to the irreversible programming signal (I_{IRP}). Reading memory cells includes: assessing (100, 110, 120, 140, 150, 160) whether a memory cell (21a, 21b) is switchable between a first state and a second state; determining that a first irreversible logic value ("1") is associated to the memory cell (21a), if the memory cell (21a) is not switchable between the first state and the second state (130); and determining that a second irreversible logic value ("0") is associated to the memory cell (21b), if the memory cell (21b) is switchable between the first state and the second state (170).

## Description

The present invention relates to a method for programming a nonvolatile memory cell, to a method for reading a nonvolatile memory cell, to a method for operating a nonvolatile memory device, to a nonvolatile memory cell programming device, to a nonvolatile memory cell reading device and to a nonvolatile memory device.

It is known that phase change memory devices, as well as most memory device of different types, must include also nonvolatile configuration cells specifically dedicated to permanently store device configuration information.

Configuration cells must have the same structure as array memory cells, since it would be too complicated and costly to integrate nonvolatile cells made by different technologies in the same die. Hence, in phase cells memory devices, configuration data are conventionally stored in form of respective resistance values associated to different states (crystalline or amorphous) of phase change material portions included in configuration cells.

For the sake of saving cost, configuration cells should be written during the so-called EWS (Electrical Wafer Sorting) process, which is carried out to test devices at wafer level, i.e. before dicing. However, devices undergo quite high temperatures during subsequent processing and information stored in configuration cells may be corrupted or even completely deleted. After cutting a wafer, in fact, high temperature bonding steps may be required to provide connections of chips to contacts pads, pins and wires. In some cases, also closing packages in which dice are encapsulated may involve considerable heating, which may alter the content of the configuration cells. Moreover, soldering operation is always required for connection to boards of electronic device.

During any one of the above process steps, the temperature of the chip may rise above about 250°C for quite a long time, so that phase change material of the configuration cells may be transformed from amorphous to crystalline state (or vice versa, although not as likely), and stored data may be corrupted. Configuration information may be irreparably lost, in which case the memory device could not be operated any longer.

The object of the invention is to provide a method for programming a nonvolatile memory cell, a method for reading a nonvolatile memory cell, a method for operating a nonvolatile memory device, a nonvolatile memory cell programming device, a nonvolatile memory cell reading device and a nonvolatile memory device, that overcome the above described limitations.

According to the present invention, a method for programming a nonvolatile memory cell, a method for reading a nonvolatile memory cell, a method for operating a nonvolatile memory device, a nonvolatile memory cell programming device, a nonvolatile memory cell reading device and a nonvolatile memory device are provided, as claimed in claims 1, 5, 10, 14, 17 and 22, respectively.

For the understanding of the present invention, some embodiments thereof will be now described, purely as non-limitative examples, with reference to the enclosed drawings, wherein:
- figure 1 is a simplified block diagram of a nonvolatile memory device according to one embodiment of the present invention;
- figure 2a is a more detailed block diagram of a portion of the nonvolatile memory device of figure 1;
- figure 2b is a flow chart of a programming method according to one embodiment of the present invention;
- figure 3 is a graph showing quantities relating to the nonvolatile memory device of figure 1;
- figure 4 is a flow chart of a reading method according to one embodiment of the present invention;
- figure 5 is a graph showing quantities relating to the nonvolatile memory device of figure 1;
- figure 6 is a simplified block diagram of a nonvolatile memory device according to another embodiment of the present invention;
- figure 7 is a more detailed block diagram of a portion of the nonvolatile memory device of figure 6;
- figure 8 is a flow chart of a reading method according to another embodiment of the present invention; and
- figure 9 is a system depiction of one embodiment of the present invention.

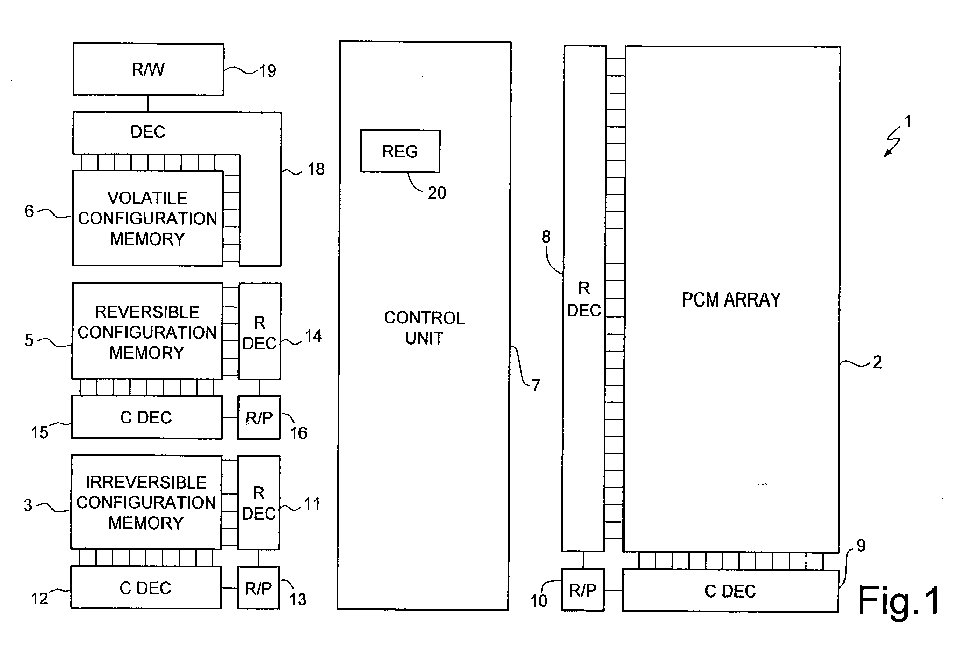

A phase change memory (PCM) device, indicated by the reference number 1 in figure 1, comprises an array 2 of PCM cells (here not shown), an irreversible configuration memory 3, a reversible configuration memory 5, a volatile configuration memory 6 and a control unit 7. The array 2 is provided with row and column decoders 8, 9 and with a conventional read/program circuit 10, which is configured to store information in PCM cells in form of resistance levels respectively associated with fully amorphous, fully crystalline or intermediate amorphous and crystalline states of phase change material portions of the PCM cells.

The irreversible configuration memory 3 includes a plurality of PCM cells and is provided with respective row and column decoders 11, 12 and with a configuration read/program circuit 13. The PCM cells of the irreversible configuration memory 3 may have the same structure as the PCM cells of the array 2. However, at least in some of the PCM cells of the irreversible configuration memory 3, data storage is made irreversible by the configuration read/program circuit 13 as explained later on.

The reversible configuration memory 5 includes a plurality of PCM cells, having the same structure as the PCM cells of the array 2, and is provided with respective row and column decoders 14, 15 and with a read/program circuit 16. The read/program circuit 16 is configured to store information in a conventional way, as the read/program circuit 10 coupled to the array 2.

In another embodiment, the array 2 and the reversible configuration memory 5 share a single read/program circuit.

The volatile configuration memory 6 is of the SRAM type and in the present embodiment is configured as a Content Addressable Memory (CAM), and is used for redundancy configuration. Dedicated addressing circuits 18 and read/write circuit 19 are coupled to the volatile configuration memory 6.

Read/program circuits 10, 16, the configuration read/program circuit 13 are communicably coupled to the control unit 7 via conventional data bus and address bus, here not shown.

The irreversible configuration memory 3 is programmed once at any convenient time, such as during EWS step, since it is capable of resisting high temperatures and is not subjected to risk of loosing data, as explained below.

The PCM device 1 is then encapsulated in a chip packaging and is mounted to a board of an electronic apparatus (here not shown). When the PCM device 1 is first powered, the control unit 7 copies the content of the irreversible configuration memory 3 into the reversible configuration memory 5. Possible changes in the structure of the PCM cells of the reversible configuration memory 5, that may have taken place in assembling steps, are cancelled by later programming operation and do not affect data that are stored in normal operation of the PCM device.

An internal, nonvolatile register 20 of the control unit 7, originally in a non-valid state (set state, i.e. crystalline,), is brought into a valid state (reset state i.e. the nonvolatile register 20 is amorphized), to indicate that the PCM device 1 has been powered at least once and the content of the irreversible configuration memory 3 has been copied into the reversible configuration memory 5.

The nonvolatile register 20 is read at every power-on and also provides a validity check for the content of the reversible configuration memory 5. If after first power-on, for any reason, the PCM device 1 is subject to temperatures able to crystallize the PCM cells and possibly corrupt the content of the reversible configuration memory 5, at the next power-on the register will result set (i.e. crystalline) and the control unit 7 will determine that it is necessary to copy once again the content of the irreversible configuration memory 3 into the reversible configuration memory 5.

At every subsequent power on, the configuration data are immediately available in the reversible configuration memory 5 and are copied into the volatile configuration memory 6 for operation. The SRAM volatile configuration memory 6 is in fact much faster than any phase change memory.

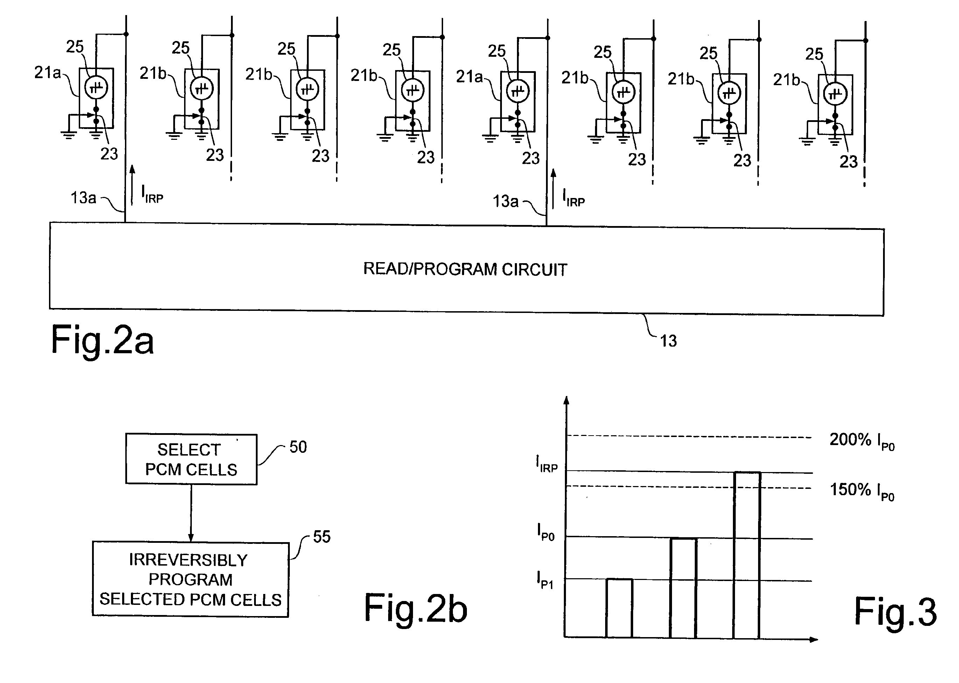

The configuration read/program circuit 13 operates under the control of the control unit 7 as hereinafter described, with reference to figures 2a, 2b and 3. In figure 2a, PCM cells of the irreversible configuration memory 3 are indicated by the reference numbers 21a, 21b and include each a selector element 23 (here a PNP transistor, sketched as a switch in figure 2a for simplicity) and a storage element 25 of a chalcogenic material (e.g. GST). A first group of PCM cells 21a are selected (figure 2b, block 50) by the row and column decoders 11, 12, not shown in figure 2a, and coupled to the configuration read/program circuit 13 to be brought into an irreversible programming state, with which a first logic value is associated ("1" in the example described; see also figure 2b, block 55). At current supply outputs 13a, the configuration read/program circuit 13 then supplies an irreversible programming current I_{IRP} that causes permanent modification in storage elements 25 of selected PCM cells 21a (which will be hereinafter indicated as exhausted PCM cells 21a). In another embodiment, irreversible modification may be achieved by applying a programming voltage.

Unselected PCM cells (from here on indicated as reversible PCM cells 21b) are not affected by the irreversible programming current I_{IRP} and maintain the capability of switching between amorphous state and crystalline state reversible even after programming. A second logic value is associated with reversible PCM cells 21b ("0" in the present embodiment).

Hence, the first and second logic values are correlated to whether or not the PCM cells are switchable between a fully crystalline state and an amorphous or fully amorphous state (it is herein understood that a fully amorphous state is a state in which at least a section of a current path of a PCM cell is completely amorphized). More precisely, the first logic value ("1") is associated to exhausted PCM cells 21a, which are not switchable between the fully crystalline state and the fully amorphous state; and the second logic value ("0") is associated to reversible PCM cells 21b, which are still switchable between the fully crystalline state and the fully amorphous state. When the irreversible configuration memory 3 is programmed, the configuration read/program circuit 13 driven by the control unit 7 converts reversible PCM cells 21b into exhausted PCM cells 21a.

Exhausted PCM cells 21a and reversible PCM cells 21b are all operative cells, i.e. cells that are used to store meaningful information.

As illustrated in figure 3, irreversible programming current I_{IRP} is higher than conventional programming current pulses normally supplied for reversible programming of PCM cells (in figure 3, programming current pulses I_{P0}, I_{P1} for bilevel PCM cells are shown). In particular, irreversible programming current I_{IRP} is in the range of 150-200% of the highest current available for reversible programming of PCM cells of either the array 2 or the reversible configuration memory 5 (I_{P1} in the example of figure 3). For example, irreversible programming current I_{IRP} may be between 1 mA and 3 mA and is applied for duration of between 1 µs and 100 µs. Following upon irreversible programming current I_{IRP}, selected PCM cells 21 are permanently modified so that storage elements 25 thereof are no longer in condition of changing their state from fully amorphous to fully crystalline.

To clarify the effect of supplying PCM cells 21 with the irreversible programming current I_{IRP}, reference will be made to the working window of PCM cells. The working window is understood as the gap between the most resistive set state (i.e. crystalline) and the least resistive reset state (i.e. amorphous) which a PCM cell may be brought into. Ageing is mostly caused by repeated conventional reversible programming cycles and tends to reduce the working window of PCM cells. Lifetime of conventional PCM cells expires when the residual working window is reduced to such an extent that the actual resistance level of the cells can not be determined with certainty, i.e. a set state and reset state can no longer be discriminated. Similar result is suddenly obtained by applying the irreversible programming current I_{IRP}, that causes overheating and strongly hastens the ageing process (hence the definition of "exhausted PCM cells 21a").

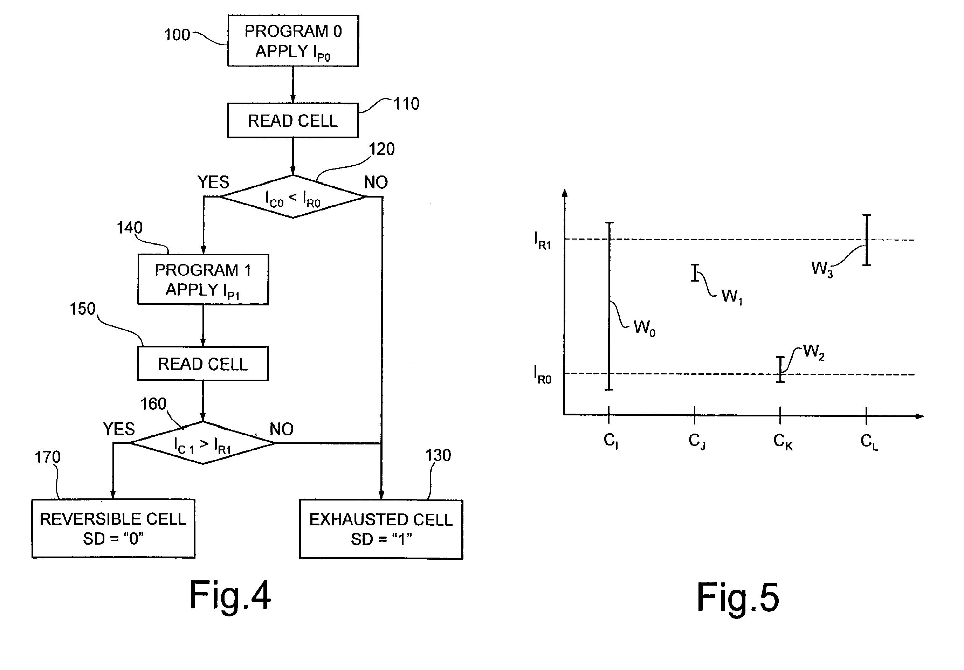

The residual working window of exhausted PCM cells 21a is eliminated or at least reduced with respect to reversible PCM cells 21b to such an extent that exhausted PCM cells 21a and reversible PCM cells 21b may be distinguished by the reading procedure described below with reference to figures 4 and 5. The reading procedure is carried out under the control of the control unit 7.

In practice, PCM cells are tested on whether they may or may not switch between a fully crystalline state and an amorphous state. Then, a logic value is associated to read PCM cells, based on the result of the test.

Initially (figure 4), first reversible programming current pulses I_{P0} are sent to a selected PCM cell 21 to be read, in a process block 100. First reversible programming current pulses I_{P0} are such that a reversible PCM cell 21b would be brought into a high resistance, low current state (fully amorphous, "0") when subjected thereto.

The selected PCM cell 21 is then biased in conventional reading conditions, in a processing block 110, and a first read current I_{C0} flowing through the selected PCM cell 21 is compared with a first reference current I_{R0}, in a test block 120.

If the first read current I_{C0} is greater than the first reference current I_{R0} (output NO from test block 120), it is determined that the selected PCM cell 21 is exhausted (process block 130), because the attempt to store a "0" has failed and selected PCM cell 21 cannot switch to a sufficiently high resistance level. Then, the stored data SD associated with the selected cell 21 has the first logic value ("1").

If, instead, the first read current I_{C0} is lower than the first reference current I_{R0} (output YES from test block 120), second reversible programming current pulses I_{P1} are sent to a selected PCM cell 21, in a process block 40. Second reversible programming current pulses I_{P1} are such that a reversible PCM cell 21b would be brought into a low resistance, high current state (fully crystalline, "1") when subjected thereto.

The selected PCM cell 21 is then read again (block 150), and a second read current I_{C1} is compared with a second reference current I_{R1}, in a test block 160. In the event the second read current I_{C1} is lower than the second reference current I_{R1} (output NO from test block 160), it is determined again that the selected PCM cell 21 is exhausted (process block 130), because the attempt to store a "1" has failed and selected PCM cell 21 cannot switch to a sufficiently low resistance level. Also in this case it is recognized that the stored data SD associated with the selected cell 21 has the first logic value ("1").

Otherwise (output YES from test block 160), it is determined that the selected PCM cell 21 is reversible (processing block 170), because it is capable of switching between sufficiently spaced apart resistance levels. It is therefore determined that the stored data SD associated with the selected PCM cell ha the second logic value ("0").

Figure 5 shows one example of a working window (designated as W₀) of a reversible PCM cell and three examples of working windows of exhausted PCM cells (designated as W₁, W₂, W₃, respectively). For the reversible PCM cell, the working window W₀ is such that the read currents in the most resistive state and in the least resistive state are respectively lower than the first reference current I_{R0} and greater than the second reference current I_{R1}. Residual working windows W₁-W₃ are not wide enough to fill the gap between the first reference current I_{R0} and the second reference current I_{R1} and, in any case, at least one of the following conditions is met:
the first read current I_{C0} is greater than the first reference current I_{R0}, or
the second read current I_{C1} is lower than the second reference current I_{R1}, so that switch into the low resistance state can not be recognized.

The above described PCM device is immune to the risk of data loss caused by high temperature processing steps, because, on the one hand, exhausted PCM cells can not be restored in their original condition and, on the other hand, reversible PCM cells are not heated so much as to lose their phase switching capability. Therefore, a PCM configuration memory may be integrated in the same chip with a conventional PCM array and may be advantageously programmed during EWS step, because irreversible programming as described prevents stored data from being corrupted by high temperature.

Exhausted PCM cells 21a may be anyway discriminated, although the resistance level and the residual working window are affected by stochastic factors and are therefore unpredictable, because the capability of switching is tested, rather than the actual resistance level.

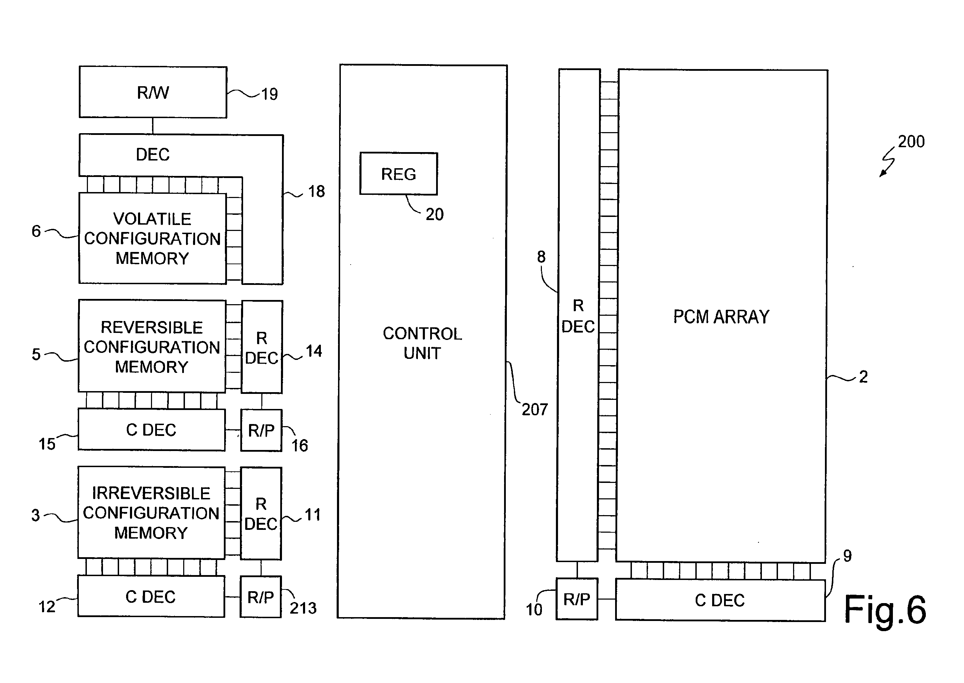

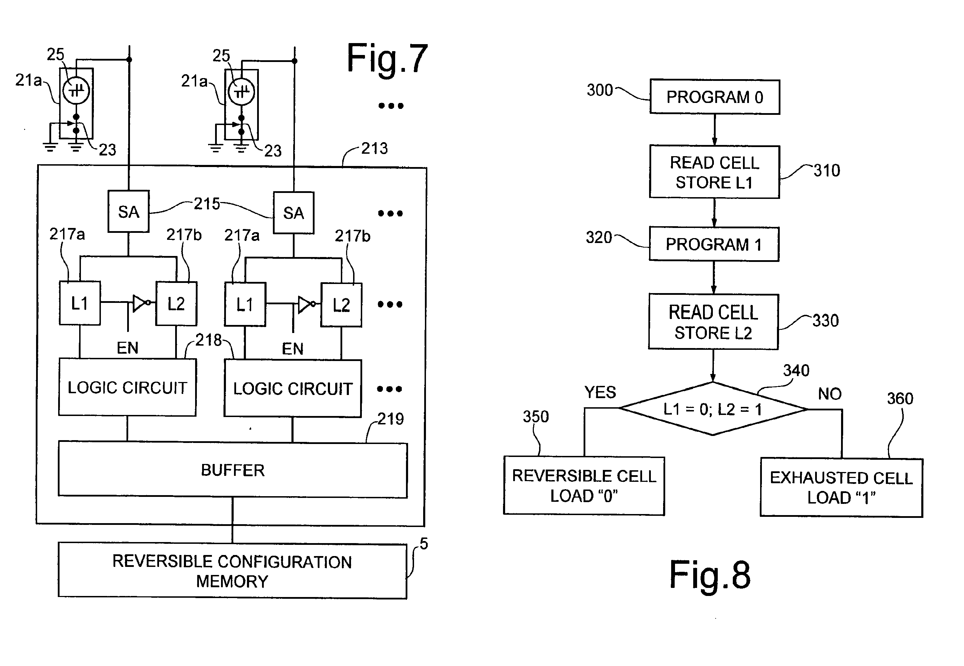

According to another embodiment, illustrated in figure 6 and 7, where parts already shown are designated by the same reference numbers, in a PCM device 200 a read/program circuit 213 is coupled to the irreversible configuration memory 3 (figure 6), is controlled by a control unit 207 and comprises a bank of sense amplifiers 215 (figure 7), each of which is connectable to selected PCM cells 21 through the row decoder 11 and the column decoder 12 for reading. The read/program circuit 213 further comprises a first latch 217a, a second latch 217b and a logic circuit 218 for each sense amplifier 215, and an output buffer register 219.

The latches 217a, 217b receive output signals from respective sense amplifiers 215. Moreover, the first latches 217a directly receive an enable signal EN, which may be generated either internally in the read/program circuit 213 or in the control unit 6. The second latches 217b receive the inverted enable signal EN. Hence, the latches 217a, 217b coupled to each sense amplifier 215 are alternatively selectable.

Outputs of the latches 217a, 217b feed into respective logic circuits 218, which are coupled to the output buffer register 219. The output buffer register 219 is in turn connectable to the reversible configuration memory 5.

The irreversible configuration memory 3 is programmed as already described. When the PCM device 200 is first operated, configuration data stored in the irreversible configuration memory 3 are read, as hereinafter described with reference to figure 8, and then loaded in the reversible configuration memory 5. Reading procedure is carried out under the control of the control unit 7.

Each selected PCM cell 21 is first subjected to reversible programming operation to store a "0" (process block 300). Then, each selected PCM cell 21 is read and the result of the reading is stored in the first latch 217a associated to the relevant sense amplifier 215 (process block 310; only one of the latches 217 of each couple is enabled by the enable signal EN).

Then, the selected PCM cell 21 are subjected to reversible programming operation to store a "1" (process block 320) and subsequently read. In this case, the result of the reading is stored in second latches 217b (process block 330).

In test block 340, the logic circuits 218 determine whether values "0" are stored in the respective first latches 217a and values "1" are stored in the respective second latches 217b. If so (output YES from the test block 340), it is determined that the coupled PCM cells are reversible PCM cells 21b and the second logic value ("0") is loaded in corresponding positions of the output buffer register 219 (process block 350). Otherwise (output NO from the test block 340), coupled PCM cells are recognized as exhausted PCM cells 21a and the first logic value ("1") is loaded in corresponding positions of the output buffer register 219 (process block 360).

In another embodiment, the logic circuits 218 may compare the content of respective first latches 217a and second latches 217b, e.g. by feeding their outputs into a XOR port. In this case, it is determined that the coupled PCM cell is a reversible PCM cell 21b, if the content of the first latch 217a is not the same as the content of the second latch 217b (the state of the selected PCM cell has changed between the first and the second reading); and it is determined that the coupled PCM cell is an exhausted PCM cell 21a if the first latch 217a and the second latch 217b have the same content (despite attempts of programming different values).

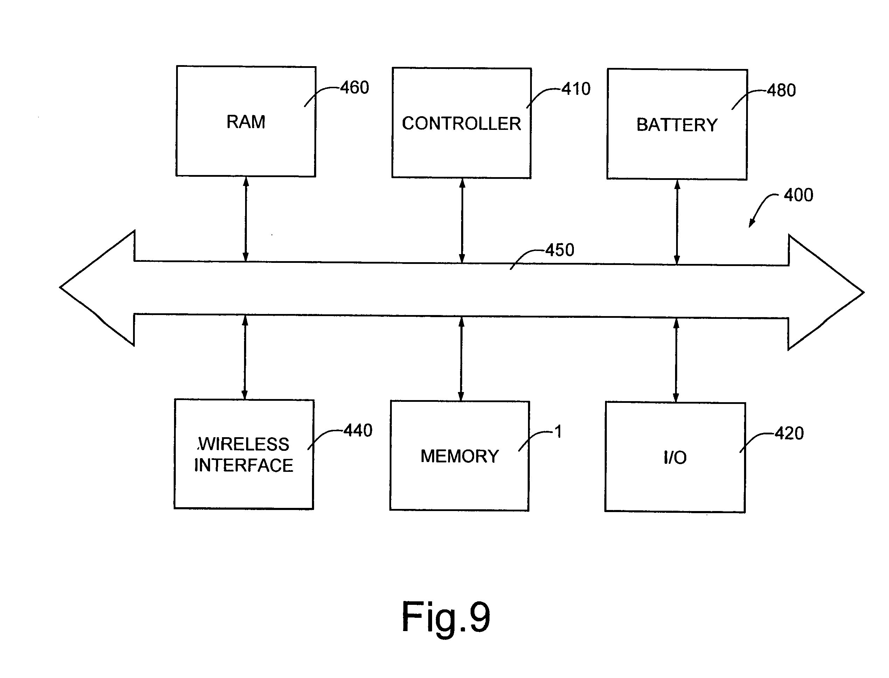

In figure 9, a portion of a system 400 in accordance with an embodiment of the present invention is illustrated. System 400 may be used in devices such as, for example, a personal digital assistant (PDA), a laptop or portable computer, possibly with wireless capability, a cell phone, a messaging device, a digital music player, a digital camera, or other devices that may be adapted to process, store, transmit or receive information and require permanent storage capability.

System 400 may include a controller 410, an input/output (I/O) device 420 (e.g. a keyboard, display), the phase-change memory device 1, a wireless interface 440, and a RAM memory 460, coupled to each other via a bus 450. A battery 480 may be used to supply power to the system 400 in one embodiment. It should be noted that the scope of the present invention is not limited to embodiments having necessarily any or all of above listed components.

Controller 410 may comprise, for example, one or more microprocessors, digital signal processors, microcontrollers, or the like.

The I/O device 420 may be used to generate a message. The system 400 may use the wireless interface 440 to transmit and receive messages to and from a wireless communication network with a radio frequency (RF) signal. Examples of the wireless interface 440 may include an antenna, or a wireless transceiver, such as a dipole antenna, although the scope of the present invention is not limited in this respect. Also, the I/O device 420 may deliver a voltage reflecting what is stored as either a digital output (if digital information was stored), or as analog information (if analog information was stored).

Finally, it is clear that numerous modifications and variations may be made to the devices and the methods described and illustrated herein, all falling within the scope of the invention, as defined in the attached claims. In particular, the invention may be exploited to make and operate any other kind of nonvolatile memory devices, besides phase-change memory devices. For example, resistive memory devices, such as RRAM or electrolytic memories, ferroelectric memories (FeRAM), Flash and EEPROM memories may be used.

## Claims

1. Method for programming a nonvolatile memory cell, comprising:
providing a nonvolatile memory cell (21a), that is reversibly switchable between a first state and a second state; and
applying an irreversible programming signal (I_{IRP}) to the nonvolatile memory cell (21a), such that the nonvolatile memory cells (21a) is made not switchable between the first state and the second state in response to the irreversible programming signal (I_{IRP}).

2. Method according to claim 1, wherein the irreversible programming signal (I_{IRP}) comprises an irreversible programming current.

3. Method according to claim 2, wherein the irreversible programming current (I_{IRP}) is in the range of 150% to 200% of a maximum reversible programming current (I₁) for the nonvolatile memory cell (21a).

4. Method according to any one of the foregoing claims, wherein applying an irreversible programming signal (I_{IRP}) comprises overheating the nonvolatile memory cell (21a).

5. Method for reading a nonvolatile memory cell, comprising:
assessing (100, 110, 120, 140, 150, 160; 300-340) whether a nonvolatile memory cell (21a, 21b) is switchable between a first state and a second state;
determining that a first irreversible logic value ("1") is associated to the nonvolatile memory cell (21a), if the nonvolatile memory cell (21a) is not switchable between the first state and the second state (130; 360); and
determining that a second irreversible logic value ("0") is associated to the nonvolatile memory cell (21b), if the nonvolatile memory cell (21b) is switchable between the first state and the second state (170; 350).

6. Method according to claim 5, wherein assessing comprises:
subjecting the nonvolatile memory cell (21a, 21b) to first reversible programming operation (100) for programming a first reversible logic value ("0");
first reading (110) the nonvolatile memory cell (21a, 21b);
determining whether a first read output signal (I_{CO}) is in a first relationship (120) with a first reference signal (I_{R0});and
deciding that the nonvolatile memory cell (21a, 21b) is not switchable between the first state and the second state (120, 130), if the first read output signal (I_{CO}) is not in the first relationship with the first reference signal (I_{RO}).

7. Method according to claim 6, wherein assessing further comprises:
if the first read output signal (I_{CO}) is in the first relationship (120) with the first reference signal (I_{R0}), subjecting the nonvolatile memory cell (21a, 21b) to second reversible programming operation (140) for programming a second reversible logic value ("1") ;
second reading (150) the nonvolatile memory cell (21a, 21b);
determining whether a second read output signal (I_{C1}) is in a second relationship (160) with a second reference signal (I_{R1}) ;
deciding that the nonvolatile memory cell (21a, 21b) is switchable between the first state and the second state (160, 170), if the second read output signal (I_{C1}) is in the second relationship (160) with the second reference signal (I_{R1}); and
deciding that the nonvolatile memory cell (21a, 21b) is not switchable between the first state and the second state, if the second read output signal (I_{C1}) is not in the second relationship (160) with the second reference signal (I_{R1}).

8. Method according to claim 5, wherein assessing comprises:
subjecting the nonvolatile memory cell (21a, 21b) to first reversible programming operation (300) for programming a first reversible logic value ("0")
first reading (310) the nonvolatile memory cell (21a, 21b);
subjecting the nonvolatile memory cell (21a, 21b) to second reversible programming operation (320) for programming a second reversible logic value ("1");
second reading (330) the nonvolatile memory cell (21a, 21b); and
comparing results (L1, L2) of the first reading (310) and of the second reading (330) with respective reference values (340).

9. Method according to claim 8, wherein assessing further comprises:
deciding that the nonvolatile memory cell (21a, 21b) is switchable between the first state and the second state (350), if both the results (L1, L2) of the first reading (310) and of the second reading (330) meet the respective reference values; and
deciding that the nonvolatile memory cell (21a, 21b) is not switchable between the first state and the second state (360), if at least one of the results (L1, L2) of the first reading (310) and of the second reading (330) does not meet the respective reference values.

10. Method for operating a nonvolatile memory device, comprising the steps of:
providing a first nonvolatile memory (3) comprising a plurality of nonvolatile memory cells (21a, 21b), that are reversibly switchable between a first state and a second state;
irreversibly programming first nonvolatile memory cells (21a) according to any one of claims 1-8;
reading the first nonvolatile memory cells (21a) and second nonvolatile memory cells (21b) according to any one of claims 9-15.

11. Method according to claim 10, further comprising first copying data stored in the first nonvolatile memory cells (21a) and in the second nonvolatile memory cells (21b) into a second nonvolatile memory (5) when the nonvolatile memory device (1; 200) is first powered.

12. Method according to claim 11, comprising checking validity of data stored in the second nonvolatile memory (5) and second copying data stored in the first nonvolatile memory cells (21a) and in the second nonvolatile memory cells (21b) into the second nonvolatile memory (5), if data stored in the second nonvolatile memory (5) are not valid.

13. Method according to claim 12, wherein checking comprises:
bringing a nonvolatile storage element (20) into a valid state when the nonvolatile memory device (1; 200) is first powered, after the first copying;
reading the nonvolatile register (20) at each power-on;
determining that data stored in the second nonvolatile memory (5) are valid if the nonvolatile register (20) is in the valid state;
determining that data stored in the second nonvolatile memory (5) are not valid if the nonvolatile register (20) is in a non-valid state; and
bringing the nonvolatile storage element (20) into the valid state if the nonvolatile storage element (20) is in the non-valid state.

14. Nonvolatile memory cell programming device, comprising a programming signal supply element (13, 13a) for applying an irreversible programming signal (I_{IRP}) to a nonvolatile memory cell (21a), that is reversibly switchable between a first state and a second state, such that the nonvolatile memory cell (21a) is made not switchable between the first state and the second state in response to the irreversible programming signal (I_{IRP}).

15. Device according to claim 14, wherein the irreversible programming signal (I_{IRP}) comprises an irreversible programming current.

16. Device according to claim 15, wherein the irreversible programming current (I_{IRP}) is in the range of 150% to 200% of a maximum reversible programming current (I₁) for the nonvolatile memory cell (21a).

17. Nonvolatile memory cell reading device, comprising:
an assessment module (100, 110, 120, 140, 150, 160; 300-340) for assessing whether a nonvolatile memory cell (21a, 21b) is switchable between a first state and a second state;
a first operative module (130; 360) coupled to the assessment module (100, 110, 120, 140, 150, 160; 300-340) for determining that a first irreversible logic value ("1") is associated to the nonvolatile memory cell (21a), if the nonvolatile memory cell (21a) is not switchable between the first state and the second state; and
a second operative module (170; 350) for determining that a second irreversible logic value ("0") is associated to the nonvolatile memory cell (21b), if the nonvolatile memory cell (21b) is switchable between the first state and the second state.

18. Device according to claim 17, wherein the assessment module (100, 110, 120, 140, 150, 160) comprises:
a first reversible programming module (100) for programming a first reversible logic value ("0") in the nonvolatile memory cell (21a, 21b);
a first reading module (110) operable for reading a first read output signal (I_{CO}) of the nonvolatile memory cell (21a, 21b), following upon operation of the first reversible programming module (100);
a first test module (120), for determining whether the first read output signal (I_{CO}) is in a first relationship (120) with a first reference signal (I_{R0}); and
a third operative module (120, 130), for deciding that the nonvolatile memory cell (21a, 21b) is not switchable between the first state and the second state, if the first read output signal (I_{CO}) is not in the first relationship with the first reference signal (I_{R0}).

19. Device according to claim 18, wherein the assessment module (100, 110, 120, 140, 150, 160) further comprises:
a second reversible programming module (140) for programming a second reversible logic value ("1") in the nonvolatile memory cell (21a, 21b), if the first read output signal (I_{CO}) is in the first relationship (120) with the first reference signal (I_{R0});
a second reading module (150) operable for reading a second read output signal (I_{C1}) of the nonvolatile memory cell (21a, 21b), following upon operation of the second reversible programming module (140);
a second test module (160), for determining whether a second read output signal (I_{C1}) is in a second relationship (160) with a second reference signal (I_{R1});
a fourth operative module (160, 170), for deciding that the nonvolatile memory cell (21a, 21b) is switchable between the first state and the second state, if the second read output signal (I_{C1}) is in the second relationship (160) with the second reference signal (I_{R1}); and
a fifth operative module (160, 130), for deciding that the nonvolatile memory cell (21a, 21b) is not switchable between the first state and the second state, if the second read output signal (I_{C1}) is not in the second relationship (160) with the second reference signal (I_{R1}).

20. Device according to claim 17, wherein the assessment module (300-340) comprises:
a first reversible programming module (300), for programming a first reversible logic value ("0") in the nonvolatile memory cell (21a, 21b);
a first reading module (310), operable for reading the nonvolatile memory cell (21a, 21b) following upon operation of the first reversible programming module (300) ;
a second reversible programming module (320) for programming a second reversible logic value ("1") in the nonvolatile memory cell (21a, 21b), after operation of the first reading module (310);
a second reading module (330), operable for reading the nonvolatile memory cell (21a, 21b) following upon operation of the second reversible programming module (320); and
a comparison module (340), for comparing output results (L1, L2) of the first reading module (310) and of the second reading module (330) with respective reference values (340).

21. Device according to claim 20, wherein the assessment module (300-340) further comprises:
a third operative module (340, 350), for deciding that the nonvolatile memory cell (21a, 21b) is switchable between the first state and the second state (350), if the output results (L1, L2) of the first reading module (310) and of the second reading module (330) meet the respective reference values; and
a fourth operative module (340, 360), for deciding that the nonvolatile memory cell (21a, 21b) is not switchable between the first state and the second state, if the output results (L1, L2) of the first reading module (310) and of the second reading module (330) do not meet the respective reference values.

22. Nonvolatile memory device, comprising a first nonvolatile array (3) having a plurality of operative nonvolatile memory cells (21a, 21b);
**characterized in that** the operative nonvolatile memory cells (21a, 21b) include:
reversible memory cells (21b) that are switchable between a first state and a second state; and
exhausted memory cells (21a) that are not switchable between the first state and the second state.

23. Device according to claim 22, further comprising a nonvolatile memory cell programming device (7, 13) configured to apply an irreversible programming signal (I_{IRP}) to selected reversible memory cells (21b), such that the selected reversible memory cells (21b) are converted into exhausted memory cells (21a) in response to the programming electrical signal (I_{IRP}).

24. Device according to claim 23, wherein the nonvolatile memory cell programming device (7, 13) is made according to any one of claims 19-23.

25. Device according to any one of claim 22-24, further comprising a nonvolatile memory cell reading device (7, 13) configured to associate a first irreversible logic value ("1") first logic value to exhausted memory cells (21a) and a second irreversible logic value ("0") to the reversible memory cells (21b).

26. Device according to claim 25, wherein the nonvolatile memory cell reading device (7, 13) is made according to any one of claims 24-28.

27. A system (400) comprising:
a processing unit (410);
an interface (440) coupled to the processing unit (410); and
a nonvolatile memory device (1) according to any one of claims 22-26, coupled to the processing unit (410).
